# EUROPÄISCHE PATENTSCHRIFT

(11) **EP 3 231 091 B1**
(45) Veröffentlichungstag und Bekanntmachung des Hinweises auf die Patenterteilung: **03.07.2024**
(21) Anmeldenummer: 15778920.7
(22) Anmeldetag: 09.10.2015
(51) Int. Cl.: H03K 17/082, H03K 17/10, H03K 17/14

(54) **VERFAHREN UND VORRICHTUNG ZUM BETREIBEN EINES SCHALTELEMENTES**
METHOD AND DEVICE FOR OPERATING A SWITCHING ELEMENT
PROCÉDÉ ET DISPOSITIF POUR FAIRE FONCTIONNER UN ÉLÉMENT DE COMMUTATION

(30) Priorität: 12.12.2014 DE 102014225755
(43) Veröffentlichungstag der Anmeldung: 18.10.2017
(73) Patentinhaber: Robert Bosch GmbH, 70442 Stuttgart (DE)
(72) Erfinder: KESSLER, Martin, 73527 Schwaebisch Gmuend (DE); UZAN, Tankut, 71732 Tamm (DE); SINN, Peter, 74199 Untergruppenbach (DE)
(86) Internationale Anmeldenummer: PCT/EP2015/073346
(87) Internationale Veröffentlichungsnummer: WO 2016/091429

(56) Entgegenhaltungen:
- WO-A1-2010/067193
- DE-A1-102006 047 243
- DE-A1-102013 212 262
- JP-A- 2013 141 409
- US-A1- 2001 002 782
- US-A1- 2012 242 376
- US-B2- 8 264 256
- Schlapbach U ET AL: "200V IGBTs operating at 200°C? An investigation on the potentials and the design constraints", , 1 May 2007 (2007-05-01), pages 1-4, XP093141764, Retrieved from the Internet: URL:https://www.5scomponents.com/pdf/ispsd _07us_copyright.pdf [retrieved on 2024-03-15]

## Beschreibung

Die Erfindung betrifft ein Verfahren und eine Vorrichtung zum Betreiben eines Schaltelementes. Ferner betrifft die Erfindung ein elektrisches System mit der Vorrichtung, ein Computerprogramm zur Durchführung dieses Verfahrens sowie ein maschinenlesbares Speichermedium.

### Stand der Technik

Schaltelemente, insbesondere Leistungshalbleiterschalter, besitzen eine temperaturabhängige Spannungsfestigkeit. Spannungsfestigkeit bedeutet in diesem Zusammenhang die Fähigkeit eines Schaltelementes, eine an den beiden Polen des Schaltelementes anliegende elektrische Spannung im geöffneten Zustand dauerhaft und sicher voneinander zu trennen. Bei niedrigeren Temperaturen beträgt die Spannungsfestigkeit eines Schaltelementes beispielsweise 600 V. Das bedeutet, dass das Schaltelement derart ausgelegt ist, dass es eine an dessen Polen anliegende Spannung von 600 V dauerhaft trennt. Bei höheren Temperaturen vermag dasselbe Schaltelement Spannungen von ca. 750 Volt voneinander zu trennen. Innerhalb bestimmter Grenzen ist eine Erhöhung der Spannungsfestigkeit von Schaltelementen zu beobachten. Für den Betrieb robuster elektronischer Schaltungen wird vorgesehen, als maximale Spannung an den Polen des Schaltelementes nur die Spannung zuzulassen, die bei den niedrigsten Betriebstemperaturen der Schaltung von dem Schaltelement sicher getrennt werden können. Somit wird das Potential der Schaltelemente bei höheren Betriebstemperaturen, bei denen auch eine höhere Spannung an den Polen des Schaltelementes sicher trennbar wäre, und somit eine höhere Leistung schaltbar wäre, nicht ausgenutzt.

Entsprechend ist aus dem Stand der Technik beispielsweise aus der DE 10 2006 047 243 A1 bekannt, ein KFZ-Bordnetz mit einem Leistungstransistor zu betreiben, wobei die elektrische Schaltung derart ausgelegt wird, dass elektrische Spannungen, die die Spannungsfestigkeit des Transistors überschreiten würden, nicht auftreten können.

Aus der US 2001/0002782 A1 ist eine Steuerung für ein elektrisches Fahrzeug bekannt, welche dazu eingerichtet ist, die Schaltverluste der Leistungsschalter eines Wechselrichters zu reduzieren, wobei die beim Schalten entstehenden Spannungsüberhöhungen auf eine Spannung begrenzt werden, die unterhalb einer zulässigen Überspannung liegt. Hierzu wird in Abhängigkeit der Temperatur der Leistungsschalter der Gatewiderstand eingestellt.

Aus der US 2012/0242376 A1 ist eine Treiberschaltung für einen Leistungsschalter bekannt, bei der die Gate-Spannung in Abhängigkeit der Temperatur des Leistungsschalters eingestellt wird.

Aus der JP 2013-141409 ist eine Treiberschaltung für einen Leistungsschalter bekannt, bei dem der Gate-Widerstand in Abhängigkeit der Temperatur des Leistungsschalters eingestellt wird.

Aus der WO 2010/067193 A1 ist eine Überstromerfassungsvorrichtung für ein Schaltelement bekannt, bei der eine Spannungsregelvorrichtung die Spannung einer Referenzspannungsquelle gemäß einer Temperatur eines Stromwandlerelements regelt.

Aus der US 8 264 256 B2 sind ein Treiber für die Ansteuerung von Halbleiterschaltern und entsprechende Verfahren bekannt.

Es besteht das Bedürfnis hierzu Alternativen zu entwickeln, die eine Ausnutzung der höheren Spannungsfestigkeit von Schaltelementen bei höheren Temperaturen ermöglichen.

### Offenbarung der Erfindung

Es wird ein Verfahren zum Betreiben eines Schaltelementes bereitgestellt, welches die folgenden Schritte aufweist:
Ermitteln einer Temperatur des Schaltelementes und Betreiben des Schaltelementes in Abhängigkeit der ermittelten Temperatur.

Es wird somit ein Verfahren bereitgestellt, mit dem ein Schaltelement in Abhängigkeit einer ermittelten Temperatur betrieben wird. Vorteilhaft ist somit ein auf die aktuelle Temperatur optimierter Betrieb des Schaltelementes möglich. Insbesondere kann die Schaltung bei der aktuellen Temperatur mit der dann möglichen maximalen Leistungen betrieben werden.

Die Schaltelemente können beispielsweise als Leistungshalbleiterschalter ausgebildet sein, insbesondere können diese Schaltelemente Feldeffekttransistoren wie MOSFETS oder bipolare Transistoren mit einem isolierten Gate (IGBT) aufweisen. Bei der Ermittlung der Temperatur sind alle üblichen Verfahren denkbar, um die Temperatur eines Schaltelementes zu bestimmen. Insbesondere kann ein Temperatursensor in der Nähe des Leistungshalbleiterschalters selber vorgesehen sein, um eine möglichst genaue Temperatur des Leistungshalbleiterschalters zu ermitteln.

In der Ausgestaltung der Erfindung weist das Verfahren folgenden weiteren Schritt auf:
Ermitteln eines zulässigen Laststroms durch das Schaltelement in Abhängigkeit der ermittelten Temperatur, wobei das Schaltelement mit einem Laststrom betrieben wird, der nicht größer als der zulässige Laststrom ist.

In Abhängigkeit der ermittelten Temperatur wird ein zulässiger Laststrom ermittelt. Die Ermittlung eines zulässigen Laststroms kann beispielsweise durch Auslesen eines Kennfeldes erfolgen. Das Kennfeld enthält hierzu Daten, welche beispielsweise aus Tabellen oder Kennlinien bezüglich der Spannungsfestigkeit der Schaltelemente bei unterschiedlichen Temperaturen entnehmbar sind. Das Schaltelement wird anschließend mit einem Laststrom betrieben, der kleiner als der zulässige Laststrom ist. Hierzu wird beispielsweise mittels Software oder einer Hardwareschaltung der zu schaltende Laststrom derart begrenzt, dass er den zulässigen Laststrom nicht übersteigt oder überschreitet. Beim Öffnen und Schließen der Schaltelemente entstehen an den Schaltelementen Überspannungen. Diese sind umso größer, je größer die Ströme sind, die mittels der Schaltelemente geschaltet werden. Zur Vermeidung zu großer Überspannungen an den Schaltelementen, die aufgrund der begrenzten Spannungsfestigkeit der Schaltelemente zur Zerstörung der Schaltelemente führen würden, wird der Laststrom durch die Schaltelemente derart begrenzt, dass dieses stets geringer ist, als der ermittelte Laststrom. So können beim Betrieb der Schaltelemente keine Überspannungen auftreten, die zu einer Zerstörung der Schaltelemente führen würden.

Vorteilhaft wird somit ein Verfahren zum Betreiben eines Schaltelementes bereitgestellt, bei dem ein sicherer Betrieb des Schaltelementes bei maximaler Ausnutzung der schaltbaren Leistung in Abhängigkeit der Temperatur ermöglicht wird.

In der Ausgestaltung der Erfindung weist das Verfahren folgende weitere Schritte auf: Vergleichen der ermittelten Temperatur mit einem Temperaturschwellwert, Erwärmen des Schaltelemente solange die ermittelte Temperatur kleiner als der Temperaturschwellwert ist.

Dies bedeutet, dass die Temperatur mit einem Temperaturschwellwert verglichen wird. Es wird somit festgestellt, ob die Temperatur des Schaltelementes geringer ist, als ein vorgebbarer Temperaturschwellwert. Der Temperaturschwellwert kann dabei derart vorgegeben werden, dass er einer Temperatur entspricht, bei der das Schaltelement eine maximale oder eine gewünschte Spannungsfestigkeit aufweist. Solange die Temperatur geringer ist als der vorgebbare Temperaturschwellwert, ist auch die Spannungsfestigkeit geringer als die maximale Spannungsfestigkeit des Schaltelementes. Damit beim Schalten die maximale Leistung geschaltet werden kann, ist es erforderlich, dass das Schaltelement eine Temperatur aufweist, die nicht geringer ist als der Temperaturschwellwert. Daher wird das Schaltelement solange erwärmt, bis die Temperatur des Schaltelementes den Temperaturschwellwert erreicht hat.

Vorteilhaft wird somit ein Verfahren bereitgestellt, welches es ermöglicht, das Schaltelement möglichst rasch zum Schalten der maximalen Leistung verwenden zu können, indem dieses aktiv erwärmt wird, bis das Schaltelement eine gewünschte Temperatur aufweist.

In einer anderen Ausgestaltung der Erfindung erfolgt das Erwärmen des Schaltelementes mittels eines vorgebbaren Laststroms durch das Schaltelement. Zur Erwärmung des Schaltelementes sind mehrere Möglichkeiten denkbar. Das Erwärmen des Schaltelementes mittels eines vorgebbaren Laststroms durch das Schaltelement ist eine besonders vorteilhafte Variante, da keine zusätzlichen Bauteile benötigt werden. Der Laststrom kann dabei so vorgegeben werden, dass eine Erwärmung des Schaltelementes erfolgt, jedoch keine Schädigung des Schaltelementes erfolgt. Alternativ ist auch das Erwärmen mittels einer Heizspirale oder anderer Varianten denkbar, bei denen das Schaltelement indirekt mittels Wärmeübertragung erwärmt wird.

In einer anderen Ausgestaltung der Erfindung wird, wenn die ermittelte Temperatur des Schaltelements größer ist als der Temperaturschwellwert oder diesem entspricht, das Schaltelement mit einem Laststrom betrieben, der nicht größer als ein vorgegebener maximaler Laststrom ist. Dies bedeutet, dass das Schaltelement zum Schalten der maximalen Leistung verwendet werden kann. Das Schaltelement kann mit einem Laststrom betrieben werden, der dem maximalen Laststrom entspricht, wenn die Temperatur des Schaltelementes nicht geringer ist als der Temperaturschwellwert. Hierzu wird beispielsweise mittels Software oder einer Hardwareschaltung der zu schaltende Laststrom derart begrenzt, dass er den maximalen Laststrom nicht übersteigt oder überschreitet. Der maximale Laststrom eines Schaltelementes kann hierfür in Abhängigkeit der maximalen Spannungsfestigkeit des Schaltelementes vorgegeben werden.

Vorteilhaft wird somit ein Verfahren bereitgestellt, welches es ermöglicht, ein Schaltelement zur Schaltung der maximalen Leistung zu verwenden.

In einer anderen Ausgestaltung der Erfindung weist das Verfahren noch den weiteren Schritt auf, dass ein Überspannungsnetzwerk bereitgestellt wird, welches auf ein Spannungspotential ausgelegt ist, welches sich bei dem vorgegebenen maximalen Laststrom ergibt.

Beim Betrieb von Schaltelementen in größeren elektrischen Netzwerken treten beim Zu- und Abschalten von leistungsstarken Verbrauchern, Überspannungen in dem elektrischen System auf. Es ist daher üblich, Überspannungsnetzwerke vorzusehen, welche die Spannungsschwankungen minimieren und somit die maximale Spannung im elektrischen System soweit reduzieren, dass die an den Schaltelementen auftretenden Spannungen geringer sind als die maximal zulässigen Spannungen aufgrund derer Spannungsfestigkeit. Diese Überspannungsnetzwerke werden gewöhnlich unter Berücksichtigung der Spannungsfestigkeit bei geringen Temperaturen der Schalter ausgelegt. Gemäß dieser Ausgestaltung der Erfindung wird das Überspannungsnetz unter Berücksichtigung der Spannungsfestigkeit bei einer Temperatur, die dem Temperaturschwellwert entspricht, ausgelegt.

Vorteilhaft wird somit das Schalten der maximalen Leistung mit dem Schaltelement ermöglicht.

Ferner wird eine Vorrichtung zum Betreiben eines Schaltelementes bereitgestellt, welche dazu eingerichtet ist, eines der beschriebenen Verfahren auszuführen. Insbesondere ist dies eine Vorrichtung, welche beispielsweise eine Ansteuerlogikeinheit umfasst. Mittels eines Temperatursensors wird die Temperatur eines Schaltelementes erfasst. Diese Temperatur kann mittels eines Vergleichers mit einem Temperaturschwellwert verglichen werden. In Abhängigkeit der Temperatur kann die Ansteuerlogikeinheit einen zulässigen Laststrom ermitteln. Die Ansteuerlogikeinheit betreibt das Schaltelement. Das Schaltelement kann insbesondere derart betrieben werden, dass der Laststrom durch das Schaltelement nicht größer als ein zulässiger Laststrom oder ein maximaler Laststrom ist.

Vorteilhaft wird somit eine Vorrichtung bereitgestellt, die ein Betreiben eines Schaltelements mit einer maximalen schaltbaren Last ermöglicht.

Ferner wird ein elektrisches System bereitgestellt, welches eine beschriebene Vorrichtung und mindestens ein Schaltelement zum Schalten eines Laststroms innerhalb eines Fahrzeuges umfasst. Vorteilhaft wird somit ein System bereitgestellt, welches den sicheren Betrieb von Schaltelementen innerhalb eines Fahrzeuges ermöglicht.

Ferner wird ein Computerprogramm bereitgestellt, welches ausgebildet ist, alle Schritte eines der genannten Verfahren auszuführen.

Ferner wird ein maschinenlesbares Speichermedium bereitgestellt, auf dem das beschriebene Computerprogramm gespeichert ist.

Es versteht sich, dass die Merkmale, Eigenschaften und Vorteile des erfindungsgemäßen Verfahrens entsprechend auf die erfindungsgemäße Vorrichtung bzw. auf das elektrische System und umgekehrt zutreffen bzw. anwendbar sind.

Weitere Merkmale und Vorteile von Ausführungsformen der Erfindung ergeben sich aus der nachfolgenden Beschreibung in Bezug auf die beigefügten Zeichnungen.

Kurze Beschreibung der Zeichnung.

Im Folgenden soll die Erfindung anhand einiger Figuren näher erläutert werden. Dazu zeigen:
Figur 1 ein elektrisches System in einer schematischen Darstellung
Figur 2 ein Verfahren zum Betreiben eins Schaltelementes Ausführungsformen der Erfindung

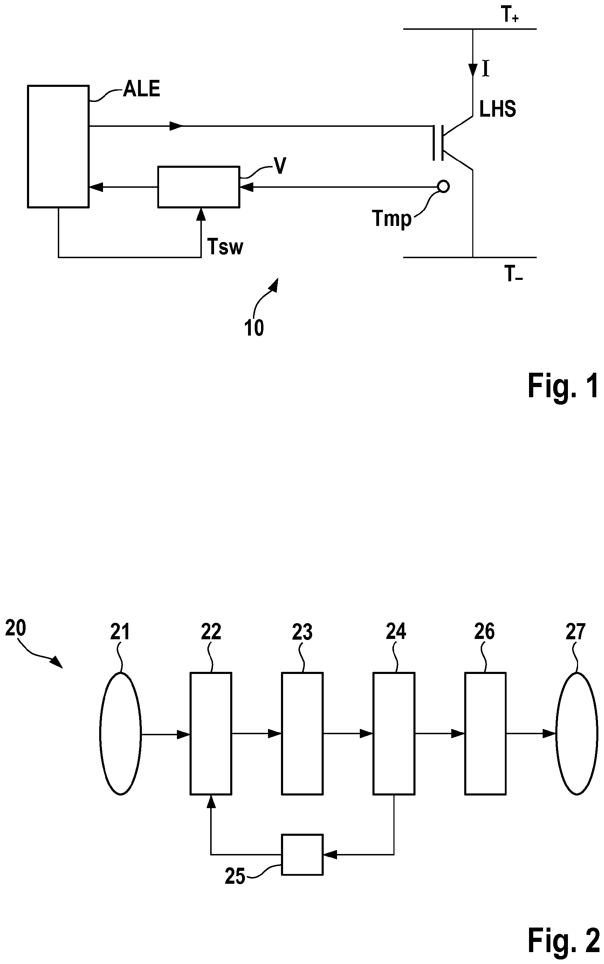

Die Figur 1 zeigt ein elektrisches System in einer schematischen Darstellung. Das elektrische System 10 umfasst mindestens ein Schaltelement LHS, insbesondere einen Leistungshalbleiterschalter, welches im geschlossenen Zustand einen Strom l von dem Potential T+ zu dem Potential T - leitet, und eine Ansteuerlogikeinheit ALE zur Ansteuerung des Schaltelementes LHS. Ein Temperatursensor ist zur Ermittlung der Temperatur Tmp vorgesehen. Die Ansteuerlogikeinheit ALE steuert das Schaltelement in Abhängigkeit von der ermittelten Temperatur Tmp an. Weiter ist eine Vergleichereinheit V zum Vergleichen der ermittelten Temperatur Tmp mit einem vorgebbarenTemperaturschwellwert Tsw dargestellt. Der Vergleicher V steht mit der Ansteuerlogikeinheit ALE in Verbindung. Die Ansteuerlogikeinheit ALE kann einen zulässigen Laststrom lz in Abhängigkeit der ermittelten Temperatur Tmp ermitteln. Die Temperatur Tmp kann, wie dargestellt, der Ansteuerlogikeinheit ALE über den Vergleicher V bereitgestellt werden, oder auch direkt von der Ansteuerlogikeinheit ALE direkt eingelesen werden.

Figur 2 zeigt ein Verfahren 10 zum Betreiben eines Schaltelementes LHS. Das Verfahren beginnt mit dem Schritt 21. Im Schritt 22 wird eine Temperatur Tmp des Schaltelementes LHS ermittelt. In Schritt 23 kann ein zulässiger Laststrom lz durch das Schaltelement LHS in Abhängigkeit der ermittelten Temperatur Tmp ermittelt werden. In Schritt 24 kann die ermittelte Temperatur Tmp mit einem Temperaturschwellwert Tsw verglichen werden. Solange die ermittelte Temperatur Tmp kleiner als der Temperaturschwellwert Tsw ist, kann das Verfahren zu Schritt 25 verzweigen. In Schritt 25 wird das Schaltelement LHS erwärmt. Dies kann insbesondere mittels Betreiben des Schaltelementes LHS mit einem geringen Laststrom l erfolgen. Von Schritt 25 verzweigt das Verfahren zurück zum Schritt 22 wo erneut die Temperatur Tmp ermittelt wird. In Schritt 26 wird das Schaltelement LHS in Abhängigkeit der Temperatur Tmp betrieben. Dabei ist insbesondere der Laststrom l durch das Schaltelement LHS nicht größer als der zulässige Laststrom lz oder, wenn die ermittelte Temperatur Tmp größer als der Temperaturschwellwert Tsw ist, ist der Laststrom I durch das Schaltelement LHS nicht größer als der maximale Laststrom Imax. Mit Schritt 27 endet das Verfahren.

## Patentansprüche

1. Verfahren (10) zum Betreiben eines Schaltelementes (LHS), mit den Schritten:
Ermitteln (22) einer Temperatur (Tmp) des Schaltelementes (LHS),
Betreiben (26) des Schaltelementes (LHS) in Abhängigkeit der ermittelten Temperatur (TmP);.
Ermitteln (23) eines zulässigen Laststroms (lz) durch das Schaltelement (LHS) in Abhängigkeit der ermittelten Temperatur (Tmp),
wobei das Schaltelement (LHS) mit einem Laststrom (l) betrieben wird, der nicht größer als der zulässige Laststrom (lz) ist;
**gekennzeichnet durch** die weiteren Schritte:
Vergleichen (24) der ermittelten Temperatur (Tmp) mit einem Temperaturschwellwert (Tsw), Aktive erwärmen (25) des Schaltelementes (LHS) solange die ermittelte Temperatur (Tmp) kleiner als der Temperaturschwellwert (Tsw) ist.

2. Verfahren nach Anspruch 1 **dadurch gekennzeichnet, dass** das Erwärmen (25) des Schaltelementes (LHS) mittels eines vorgebbaren Laststroms (Iv) durch das Schaltelement (LHS) erfolgt.

3. Verfahren nach Anspruch 1 mit dem weiteren Schritt:
wenn die ermittelte Temperatur (Tmp) größer als der Temperaturschwellwert (Tsw) ist, Betreiben (26) des Schaltelementes (LHS) mit einem Laststrom (I), der nicht größer als ein vorgegebener maximaler Laststrom (Imax) ist.

4. Verfahren nach Anspruch 3 mit dem weiteren Schritt:
Bereitstellen eines Überspannungsnetzwerks, welches auf ein Spannungspotential ausgelegt ist, das sich bei dem vorgegebenen maximalen Laststrom (Imax) ergibt.

5. Vorrichtung (ALE) zum Betreiben eines Schaltelementes, welche dazu eingerichtet ist, ein Verfahren (20) gemäß einem der Ansprüche 1 bis 4 auszuführen.

6. Elektrisches System (10), umfassend eine Vorrichtung (ALE) gemäß Anspruch 5 und mindestens ein Schaltelement (LHS) zum Schalten eines Laststroms (l) innerhalb eines Fahrzeuges.

7. Computerprogramm, das ausgebildet ist, alle Schritte eines der Verfahren (20) nach einem der Ansprüche 1 bis 4 auszuführen.

8. Maschinenlesbares Speichermedium, auf dem das Computerprogramm nach Anspruch 7 gespeichert ist.

## Claims

1. Method (10) for operating a switching element (LHS), comprising the following steps:
determining (22) a temperature (Tmp) of the switching element (LHS),
operating (26) the switching element (LHS) depending on the determined temperature (Tmp);
determining (23) a permissible load current (Iz) through the switching element (LHS) depending on the determined temperature (Tmp),
wherein the switching element (LHS) is operated using a load current (I) that is not greater than the permissible load current (Iz);
**characterized by** the further steps of:
comparing (24) the determined temperature (Tmp) with a temperature threshold value (Tsw),
actively heating (25) the switching element (LHS) as long as the determined temperature (Tmp) is lower than the temperature threshold value (Tsw).

2. Method according to Claim 1, **characterized in that** the switching element (LHS) is heated (25) by means of a predefinable load current (Iv) through the switching element (LHS).

3. Method according to Claim 1, comprising the further step of:
when the determined temperature (Tmp) is greater than the temperature threshold value (Tsw), operating (26) the switching element (LHS) using a load current (I) that is not greater than a predefined maximum load current (Imax).

4. Method according to Claim 3, comprising the further step of:
providing an overvoltage network, which is designed for a voltage potential that arises at the predefined maximum load current (Imax).

5. Device (ALE) for operating a switching element, which device is configured to perform a method (20) according to one of Claims 1 to 4.

6. Electrical system (10), comprising a device (ALE) according to Claim 5 and at least one switching element (LHS) for switching a load current (I) within a vehicle.

7. Computer program, which is designed to perform all the steps of one of the methods (20) according to one of Claims 1 to 4.

8. Machine-readable storage medium on which the computer program according to Claim 7 is stored.

## Revendications

1. Procédé (10) de commande d'un élément de commutation (LHS), avec les étapes suivantes :
déterminer (22) une température (Tmp) de l'élément de commutation (LHS),
faire fonctionner (26) l'élément de commutation (LHS) en fonction de la température déterminée (TmP) ;
déterminer (23) un courant de charge admissible (Iz) à travers l'élément de commutation (LHS) en fonction de la température déterminée (Tmp),
l'élément de commutation (LHS) fonctionnant avec un courant de charge (I) qui n'est pas supérieur au courant de charge admissible (Iz) est :
**caractérisé par** les étapes supplémentaires suivantes :
comparer (24) la température déterminée (Tmp) avec un seuil de température (Tsw),
chauffer activement (25) l'élément de commutation (LHS) tant que la température déterminée (Tmp) est inférieure au seuil de température (Tsw).

2. Procédé selon la revendication 1, **caractérisé en ce que** l'élément de commutation (LHS) est chauffé (25) au moyen d'un courant de charge (Iv) prédéterminé à travers l'élément de commutation (LHS).

3. Procédé selon la revendication 1, avec l'étape supplémentaire suivante :
si la température déterminée (Tmp) est supérieure à la valeur seuil de température (Tsw), faire fonctionner (26) l'élément de commutation (LHS) avec un courant de charge (I) qui n'est pas supérieur à un courant de charge maximal prédéterminé (Imax).

4. Procédé selon la revendication 3, avec l'étape supplémentaire suivante :
fournir un réseau de surtension conçu pour un potentiel de tension résultant du courant de charge maximal spécifié (Imax).

5. Dispositif (ALE) pour commander un élément de commutation, qui est configuré pour mettre en œuvre un procédé (20) selon l'une des revendications 1 à 4.

6. Système électrique (10), comprenant un dispositif (ALE) selon la revendication 5 et au moins un élément de commutation (LHS) pour commuter un courant de charge (I) à l'intérieur d'un véhicule.

7. Programme informatique conçu pour mettre en œuvre toutes les étapes d'un des procédés (20) selon l'une des revendications 1 à 4.

8. Support de stockage lisible par machine sur lequel le programme informatique selon la revendication 7 est stocké.
